Europäisches Patentamt

(19) European Patent Office

Office européen des brevets

(11) Publication number: **0 000 585**
**B1**

(12) **EUROPEAN PATENT SPECIFICATION**

(45) Date of publication of patent specification: **09.03.83**

(21) Application number: **78100520.2**

(22) Date of filing: **27.07.78**

(51) Int. Cl.³: **H 02 H 5/00, H 02 H 3/04, G 01 R 31/00, G 05 B 9/00**

(54) Automatic control system for processing signals from an overheat monitor of a dynamoelectric machine.

(30) Priority: **01.08.77 US 820608**

(43) Date of publication of application:
**07.02.79 Bulletin 79/3**

(45) Publication of the grant of the patent:
**09.03.83 Bulletin 83/10**

(84) Designated Contracting States:
**CH DE FR GB**

(56) References cited:
**DE - A - 2 247 114**
**FR - A - 2 072 938**
**US - A - 2 175 893**
**US - A - 3 585 451**
**US - A - 3 807 218**
**IEEE TRANSACTIONS ON POWER APPARATUS AND SYSTEMS, vol. PAS-92, no. 2, March/April 1973,**
**New York**
**C. C. CARSON et al. "Immediate warning of local overheating in electric machines by the detection of pyrolysis products", pages 533 to 542.**

(73) Proprietor: **GENERAL ELECTRIC COMPANY**
**1 River Road**
**Schenectady New York 12305 (US)**

(72) Inventor: **Sawada, Fred Hiroshi**
**1022 Tomahawk Trail**
**Scotia New York 12302 (US)**
Inventor: **Echeverria, Federico Sergia**
**R.D. No. 1 2 Dawn Drive**
**Scotia New York 12302 (US)**
Inventor: **Barton, Sterling Cheney**
**11 Bromley Place**
**Scotia New York 12303 (US)**
Inventor: **Carson, Chester Carroll**
**12 Currie Court R.D. 8**
**Ballston Spa New York 12020 (US)**

(74) Representative: **Voigt, Reinhard, Dipl.-Ing. et al,**
**Kaiserstrasse 41**
**D-6000 Frankfurt (Main) 1 (DE)**

## Automatic control system for processing signals from an overheat monitor of a dynamoelectric machine

This invention relates to a system for processing signals from an overheat monitor for a gas-cooled dynamoelectric machine. In particular the invention concerns an electronic control which automatically determines the validity of an apparent overheating signal and initiates a reduction in machine load or a monitor malfunction signal.

Overheating in stator cores of gas-cooled dynamoelectric machines, such as that resulting from foreign object damage to stator teeth allowing electrical contact between core laminations and thus resistance heating, can rapidly cause local melting of core laminations, leading to costly machine repairs and outages. To minimize damage, it is very desirable to detect overheating in its earliest stages so that load carried by the machine can be reduced and appropriate corrective action taken at minimal cost and outage time.

Systems for detection of machine overheating are disclosed in IEEE Transactions on Power Apparatus and Systems, Vol. PAS-92, No. 2, March/April 1973, pages 533 to 542, and several U.S. patents assigned to the assignee of the present invention, i.e., 3,427,880 to Grobel et al; 3,573,460 to Skala; 3,702,561 and 3,916,671 to Carson et al, the disclosures of which are incorporated herein by reference thereto. The systems described therein are based primarily on the principle that at onset of overheating in a dynamo-electric machine, decomposition of materials such as the coatings normally applied to certain machine parts (or intentionally applied for the express purpose of detecting overheating) yields pyrolysate products including submicron particles, which become entrained in the machine gas coolant. This gas coolant is ionized in an ion chamber detector and electrical current resulting from the ionized gas is measured to determine whether submicron particles are present; the presence of submicron particles causes a measurable decrease in current because some ions collide with and attach themselves to the particles, decreasing the mobility of these ions and the likelihood of their collection and contribution to ion current.

This ion chamber detector is applied to an overheat monitor in U.S. patent 3,427,880 to Grobel et al according to which disclosure a portion of the gas coolant from a dynamo-electric machine is passed through the ion chamber detector and the resulting current monitored for presence of pyrolysates.

Further refinements to overheat detectors are disclosed in U.S. patents 3,702,561 and 3,916,671 to Carson et al and U.S. patent 4,082,948 to Barton et al. In the disclosure of U.S. patent 3,702,561 a submicron particle filter is included to remove particles from the gas coolant and verify the overheat signals by detection of an increase in ion current level, and a coated filament is provided to check the performance of the detector by producing pyrolysate particles to simulate overheating. U.S. patent 3,916,671 discloses the addition of gas chromatographic apparatus to the monitor system for identifying specific pyrolysate materials and thus their source within the machine. U.S. patent 4,082,948 discloses the use of two ion chamber detectors, one of which can be heated to gasify any oil mist particles present, thus providing means for differentiation between a detector output due to machine overheating and a detector output due to oil mist particles entrained in the gas coolant.

While the foregoing prior art structures represent significant advances in early detection of local overheating in a dynamoelectric machine, their use in practice has not been as effective as may be desired because of the lengthy period of time required to fully respond to a machine overheat and because the judgment and actions of each individual machine operator may lead to different and sometimes inappropriate responses to apparent overheating. Thus in certain circumstances and installations, as much as five minutes may elapse after onset of overheating before corrective action in completed; during this time there is first cognizance of apparent overheating, followed by dispatch of personnel to the location of the overheat detector (which may be remote from the main control room), then activation by these personnel of a verification system such as a particle filter, and finally, after overheating is validated, a reduction in machine load to a level where overheating ceases or the excitation system and main line breaker of the machine may be tripped. During the several minutes which elapse prior to reduction of load to safe operating levels serious damage may occur to the machine such as melting of the core. Alternatively, if load reduction or runback is initiated prior to validation of overheating, unnecessary loss of power generation and inefficient use of fuel may occur if, after a lengthy verification sequence, the drop in signal is proved spurious, e.g., caused by ion chamber detector current leakages, calibration errors, or other malfunctions associated with peripheral recording and amplification equipment of the monitor.

Accordingly, it is a general object of the invention to provide a system to automatically process signals from an overheat monitor for a gas-cooled dynamoelectric machine of the type used to generate electrical current in response to a rotating field.

The control system according to the invention includes an overheat network responsive to said overheat signal and adapted to initiate a reduction in the loading of said dynamoelectric machine in response to a rise in said monitor signal to a second preselected value within a preselected interval of time after said monitor signal drops to a first preselected value, and is characterized by a trip network adapted to disconnect the excitation system and the load from said dynamoelectric machine in response to the combination of a rise in said monitor signal to said second preselected value within a first preselected interval of time after said monitor signal drops to said first preselected value and the existence of a monitor signal less than or equal to said first preselected value at the expiration of a second preselected interval of time after said monitor signal rises to said second preselected value.

Preferred embodiments of the invention are characterized in the subclaims.

The invention will become more readily apparent from the following description of a preferred embodiment thereof shown, by way of example, in the accompanying drawings, in which:

FIG. 1 is a simplified block diagram;

FIG. 2 is a block diagram of a preferred arrangement of the control system in accordance with the invention;

FIG. 3 is a drawing of typical monitor signal variations with time indicating various steps in the control sequence; and

FIG. 4 is a schematic diagram of the control system.

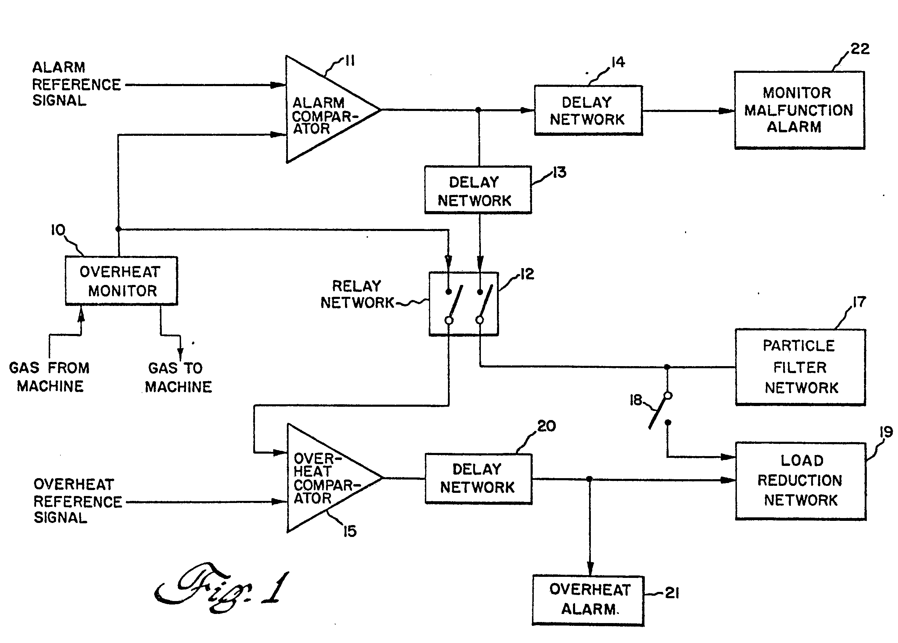

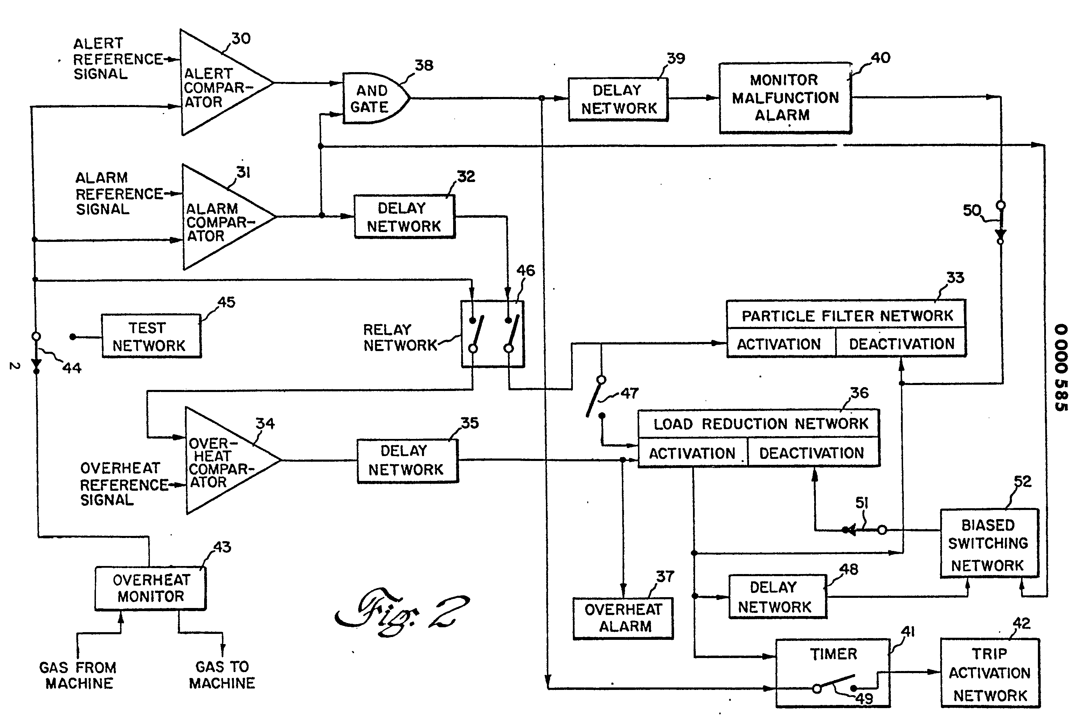

FIG. 1 shows a simplified block diagram in which an overheat monitor 10 is used to monitor gas used to cool a dynamoelectric machine (not shown) which includes a rotor having a rotatable field and a stator whose windings, may also be cooled internally with a liquid. The monitor 10 produces a monitor signal which is applied to the input of alarm comparator 11 and to the input of relay network 12. If due to machine overheating or a monitor malfunction, the monitor signal drops to a level equal to that of an alarm reference signal also applied to the input of alarm comparator 11, comparator 11 is energized and its output is fed to delay networks 13 and 14. After a suitable delay in network, relay network 12 is tripped. This couples the monitor signal to overheat comparator 15 and energizes the particle filter network 17, causing gas flowing through the overheat monitor 10 to pass through a particle filter which removes any pyrolysate particles present in the gas flow. In one mode of operation of the invention, with switch 18 preset in a closed position, load reduction network 19 is also triggered. If machine overheating is occurring, the monitor signal will rise in response to removal of pyrolysate particles by the particle filter, de-energizing alarm comparator 11. When the monitor signal recovers to the level of the overheat reference signal applied to the input of overheat comparator 15, comparator 15 is energized. The output from comparator 15, after a suitable delay in delay network 20, triggers overheat alarm 21 and load reduction network 19, the latter initiating reduction of load applied to the machine in an attempt to minimize damage and eliminate overheating. If, however, overheating is not occurring and pyrolysate particles are thus not present in the gas flow, application of the filter to the gas flow will not cause a rise in the monitor signal to deenergize alarm comparator 11 or energize overheat comparator 15. Instead, after a suitable delay in network 14, monitor malfunction alarm 22 is triggered, indicating that the initial drop in monitor signal was not due to overheating but to a malfunction such as leakage of coolant gas or problems with the ion chamber or peripheral equipment of the overheat monitor 10.

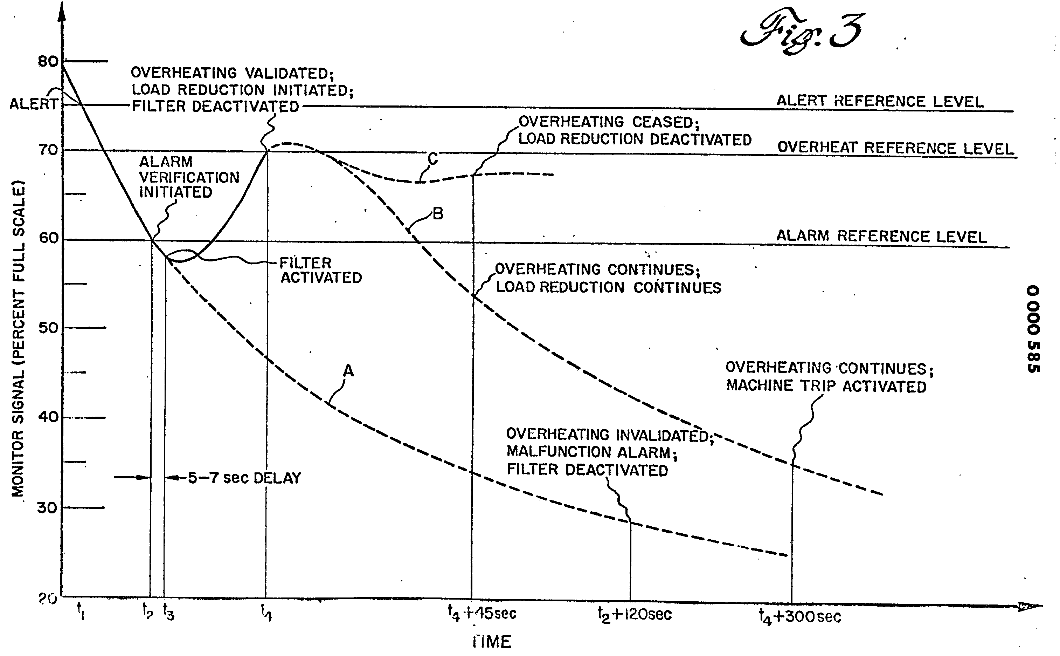

FIG. 2 illustrates the major networks of a preferred embodiment of the invention and the flow of signals during its operation. This preferred arrangement of the control system comprises an alert network including alert comparator 30 and a light-emitting diode (not shown); an alarm network including alarm comparator 31, delay network 32, and particle filter network 33; an overheat network including overheat comparator 34, delay network 35, load reduction network 36 and overheat alarm 37; a malfunction network including AND gate 38, delay network 39, and monitor malfunction alarm 40; and a trip network including timer 41 and trip activation network 42.

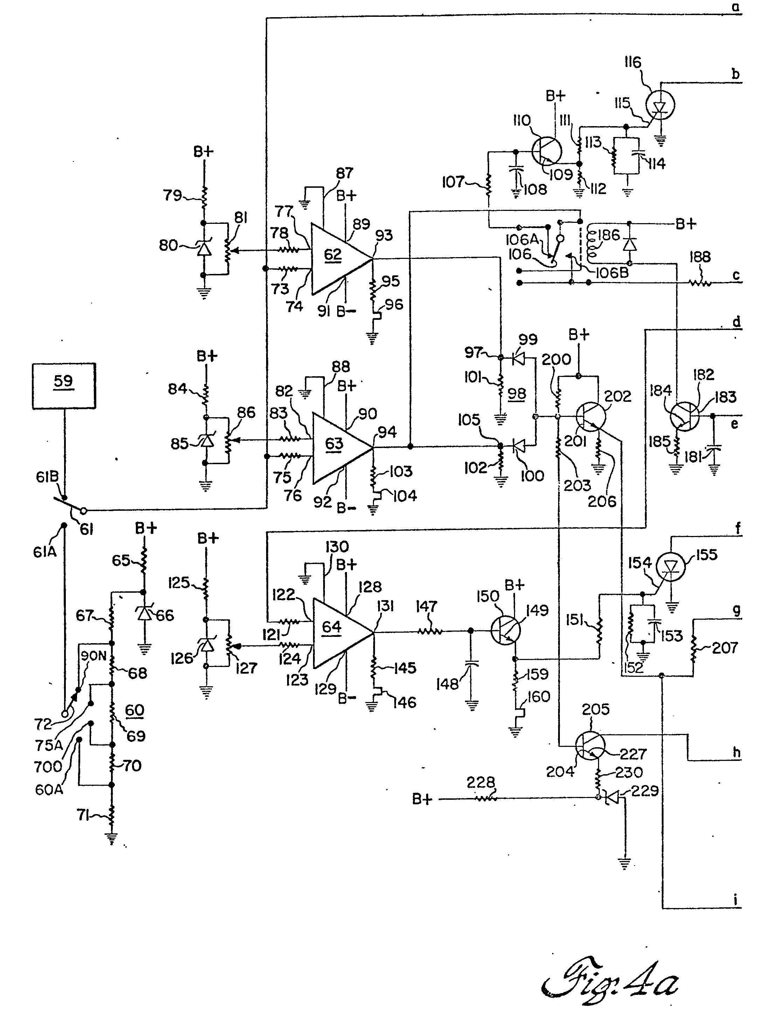

Signals are applied to the control system from overheat monitor 43, or, if switch 44 is connected to test network 45, from test network 45, which may be used to check operation of the control system by applying to it signals simulating machine overheating or monitor malfunction. Overheat monitor 43 may be of the type shown and described in U.S. patents 3,427,880 to Grobel et al and 3,702,561 to Carson et al, and includes a particle filter which can be activated for removal of submicron particles from gas coolant flow and typically also includes a recorder for plotting monitor signals on a time chart, and a signal amplifier. The monitor signals, a direct current produced by amplifying the ion current of the overheat monitor, is applied to the inputs of alert comparator 30, alarm comparator 31, and, through the action of relay network 46, to the input of overheat comparator 34. Also applied to the inputs of each comparator is a suitable reference signal whose value establishes the monitor signal level required to energize each comparator. At the onset of local overheating in a machine, submicron pyrolysate particles are released into the gas coolant flow from the dynamoelectric machine to the overheat monitor 43 causing a drop in monitor current signal. Now, with reference also the solid line of FIG. 3, which shows a typical monitor signal pattern during overheating and its verification in accordance with the invention, if the monitor current signal drops to the level of the alert reference signal (for example to 75 percent of full scale value on the recorder of the overheat monitor 43), alert comparator 30 is energized and its output is fed to AND gate 38. A further drop in monitor signal to the level of the alarm reference signal applied to the input of alarm comparator 31 (for example to 60 percent of full-scale value) will energize alarm comparator 31 and initiate verification of machine overheating. The output of comparator 31 is fed to AND gate 38 and to delay network 32. After a suitable delay such as 6 seconds to protect the system from surges or transients, relay network 46 is tripped; this couples the overheat monitor signal to the input of overheat comparator 34 and energizes the particle filter network 33. At this point, switch 47, through its connection to load reduction network 36, provides the option of reducing load on the machine immediately after tripping of relay network 46; however, in the preferred arrangement shown in FIG. 2, switch 47 is set in the open position so that load reduction network 36 is not triggered until after validation of overheating. Verification of overheating thus proceeds as the particle filter of the overheat monitor 43, activated by particle filter network 33, removes submicron particles from the gas flow, causing monitor signal current to recover. When monitor signal current rises to the level of the overheat reference signal applied to the input of overheat comparator 34, shown as 70 percent full value in FIG. 3, comparator 34 is energized, validating or confirming overheating of the dynamoelectric machine. The output of comparator 34 is delayed for 1—2 seconds in delay network 35 to protect the system from transients and surges, then triggers load reduction network 36 which initiates a reduction in load, trips overheat alarm 37, and sends a signal to delay network 48. Since filtration of pyrolysate particles is no longer desired, a signal is also sent to particle filter network 33, de-energizing the filter. The output signal from overheat comparator 34 is also fed into timer 41 which after a preset interval of time, for example five minutes, closes switch 49, passing the output of AND gate 38 to trip activation network 42. If the output of AND gate 38 is positive, indicating continued overheating (monitor signal less than or equal to 60 percent) in spite of load reduction, trip activation network 42 will be energized, disconnecting the excitation system and the main line breaker of the dynamoelectric machine, the latter uncoupling the remaining load from the machine.

If a drop in monitor signal current occurs for reasons other than machine overheating, filtration of the gas passing through overheat monitor 43 will not result in a recovery of monitor signal but instead the monitor signal may continue to drop as indicated by dashed line A of FIG. 3. In the preferred arrangement (FIG. 2) the application of output signals from alert comparator 30 and alarm comparator 31 to the input of AND gate 38 after the monitor signal drops to the 60 percent level will produce an output from AND gate 38 which is fed into delay network 39. After a delay of approximately two minutes to allow time for particle filtration and recovery of the monitor signal had actual machine overheating been in progress, monitor malfunction alarm 40 is triggered, and if switch 50 is preset in a closed position, the particle filter is deenergized by the deactivation portion of particle filter network 33.

As an additional option of the control system, an automatic cycling feature is provided whereby (with switch 51 closed) after validation of overheating, the signal sent into delay network 48, which imposes a delay of about 45 seconds, passes into biased switching network 52. If overheating has ceased and the monitor signal from overheat monitor 43 is above the alarm reference signal (e.g., 60%) as indicated by the dashed curve C of FIG. 3, biased switching network 52 will provide an output triggering deactivation of load reduction by the deactivation portion of network 36. If overheating is continuing (dashed curve B of FIG. 3), the signal from reenergized alarm comparator 31 will not trigger load reduction deactivation through switching network 52, and load reduction of the machine will continue.

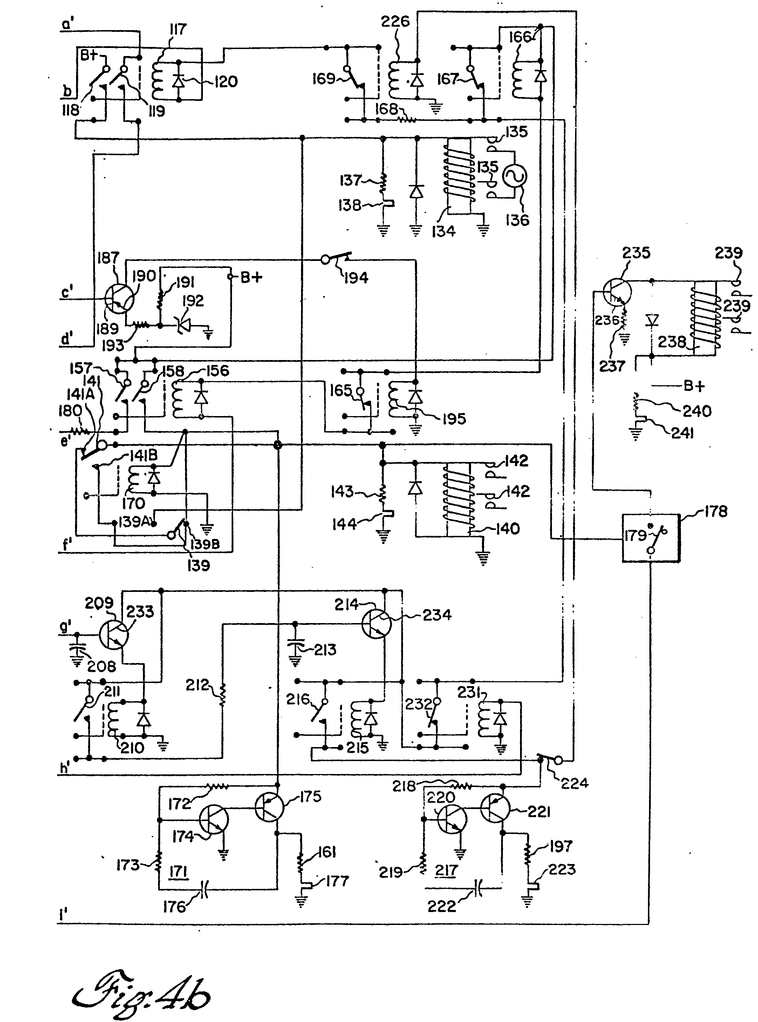

FIG. 4 shows a detailed schematic diagram of a preferred arrangement of the control system illustrated in the block diagram of FIG. 2 wherein all points marked B+ are connected by a common bus line (not shown) to a positive regulated DC voltage supply and all points marked B— are connected by a common bus line (not shown) to a negative regulated DC supply voltage. A signal from either overheat monitor 59 or test network 60 is fed through switch 61 to the input of alert comparator 62 and alarm comparator 63, which, along with overheat comparator 64, are solid-state highspeed voltage comparators. Test network 60 includes resistor 65 and zener diode 66, series-connected resistors 67, 68, 69, 70 and 71, and a 4-position selector switch 72 and allows various current signal inputs to be fed to the control system to simulate machine overheating or monitor malfunction. In the non-test operating mode shown, which switch 61 connected to terminal 61B, a current signal is fed from overheat monitor 59 through resistor 73 to the inverting input terminal 74 of alert comparator 62 and through resistor 75 to the inverting terminal 76 of alarm comparator 63. Also applied to non-inverting input terminal 77 of alert comparator 62 through resistor 78 is a reference signal from an alert reference network comprising resistor 79, zener diode 80, and potentiometer 81. A similar reference signal of appropriate level is fed to the non-inverting input terminal 82 of alarm comparator 63 through resistor 84, zener diode 85, and potentiometer 86. Comparators 62 and 63 also include, respectively, terminals 87 and 88 connected to ground, 89 and 90 to positive regulated DC voltage supply B+, 91 and 92 to negative regulated DC voltage supply B—, and output terminals 93 and 94.

When the monitor signal from overheat monitor 59 decreases to the value of the alert reference signal applied to alert comparator 62, comparator 62 is activated, generating an output signal which passes through resistor 95 and turns on light-emitting diode (LED) 96 and is also fed into input terminal 97 of AND gate 98 which includes diodes 99 and 100 and resistors 101 and 102. As the monitor signal decreases to the value of the alarm reference signal applied to alarm comparator 63, comparator 63 is activated, producing an output which passes through resistor 103 and turns on LED 104, is fed into input terminal 105 of AND gate 98, and also passes through switch 106 (which is normally connected to terminal 106A) into an RC delay network consisting of resistor 107 and capacitor 108. After a delay of about 6 seconds, emitter 109 of transistor 110 passes an output signal through a voltage dividing and noise-suppressing network including resistors 111 and 112 and resistor 113 and capacitor 114, to the gate 115 of silicon-controlled rectifier (SCR) 116, firing SCR 116 which in turn energizes relay 117, closing switches 118 and 119. It will be understood that relay 117 and each of the relays to be described herein are connected in parallel to suitable protective diodes such as diode 120 which clip or suppress voltage spikes induced by the relays. Closure of switch 119 couples the monitor signal from overheat monitor 59 to overheat comparator 64 by feeding the signal through resistor 121 to the non-inverting input, terminal 122 of comparator 64. Overheat comparator 64 also includes inverting input terminal 123, which receives an overheat reference signal through resistor 124 from a reference network including resistor 125, zener diode 126, and potentiometer 127, and also includes terminals 128 and 129 connecting the comparator 64 to positive voltage supply B+ and negative voltage supply B—, terminal 130 to ground, and output terminal 131. Closure of switch 118 by relay 117 connects the B+ source to particle filter relay coil 134, closing its contacts 135 to a 115 volt AC source 136, energizing a solenoid valve (not shown) which causes gas in the overheat monitor 59 to flow through a particle filter (not shown). Closure of switch 118 also causes a signal to pass through resistor 137 and turn on LED 138. If switch 139 is preset in position connecting it to terminal 139A, closure of switch 116 also will connect the B+ voltage source to load reduction relay coil 140 through switch 141, normally connected to terminal 141A, closing the contacts 142 of relay coil 140 which energizes various relays in a runback network (not shown) which initiates a scheduled reduction in machine load. A signal will also pass through resistor 143 and turn on LED 144.

Introduction of the particle filter into the system causes removal of pyrolysate particles present in the gas coolant from machine overheating, and removal results in an increase in monitor current signal. When monitor signal recovers to the value of the overheat reference signal applied to overheat comparator 64, comparator 64 is activated, producing an output which passes through resistor 145 and turns on LED 146 and also passes into RC charging network consisting of resistor 147 and capacitor 138. After a delay of 1—2 seconds, emitter 149 of transistor 150 applies a triggering pulse through a voltage dividing and noise-suppressing network including resistors 151 and 159 and resistor 152 and capacitor 153 to the gate 154 of SCR 155, firing SCR 155 which in turn energizes relay 156, closing switches 157 and 158. The output from transistor 150 also passes through resistor 159 and turns on LED 160. Energization of relay 156, in addition to closing switches 157 and 158, feeds a signal through normally closed switch 165 to relay 166, opening normally closed switch 167. Opening of switch 167 de-energizes relay 117 through the interconnecting network including resistor 168 and normally closed switch 169 and thus uncouples the particle filter from the system (and for a brief interval cuts off power from the load reduction relay coil 140 if switch 139 is connected to terminal 139A). Closure of switch 158 energizes relay 170 which moves switch 141 to terminal 141B, coupling the B+ voltage to load reduction relay coil 140. If switch 139 is preset in position connecting it to terminal 139B, machine load reduction is initiated at this point; if switch 139 is preset to terminal 139A, load reduction, briefly interrupted, is now re-initiated. Closure of switch 158 also activates overheat flashing alarm network 171 which includes resistors 172 and 173, transistors 174 and 175, capacitor 176, resistor 161, and light-emitting diode 177, and also sends an input signal to adjustable timer 178, a commercial timer which may, for example, be a series 3810 solid-state time delay relay type 10106 made by Cramer Controls Company of Old Saybrook, Connecticut, which is preset to close switch 179 at an interval such as 5 minutes after the closure of switch 158. Closure of switch 157 applies the B+ voltage source through the RC charging network comprising resistor 180 and capacitor 181 to the base 182 of transistor 183. After a 45-second delay, transistor 183, whose emitter 184 is connected to ground through resistor 185, conducts and relay 186 is energized, moving switch 106 to terminal 106B, which applies the output signal of alarm comparator 63 to transistor 187 through resistor 188. Transistor 187 is biased off as long as alarm comparator 63 is activated since the difference between the positive output of comparator 63 applied to base 189 of transistor 187 and the voltage applied to its emitter 190 from voltage source B+ through the network including resistor 191, zener diode 192, and resistor 193 is less than the threshhold voltage for conduction. However, if after load runback is initiated and the particle filter is deactivated, monitor signal recovers to or remains at a level in excess of the alarm reference signal (curve C of FIG. 3), comparator 63 quenches and its output decreases to a small negative value. Transistor 187 then conducts and, if switch 194 is set in the preferred closed position, relay 195 is energized, opening switch 165 which in turn opens switches 157 and 158 de-energizing the machine load reduction coil 140, overheat flashing alarm network 171, and SCR 155.

The remainder of the control system illustrated in FIG. 4 processes monitor signals which vary for reasons other than overheating or initiates tripping of the machine if load reduction does not eliminate overheating. If the monitor signal decreases for causes not associated with overheating, filtering of the gas flow will not cause a recovery in monitor signal and hence overheat comparator 64 will not be activated. Instead, a decreasing monitor signal will cause activation of comparators 62 and 63, and the application of output from these two comparators to the input of AND gate 98 activates AND gate 98. The output signal from AND gate 98 is combined with a signal from the B+ voltage source through resistor 200 and is applied to the base 201 of transistor 202 and is also applied through resistor 203 to the base 204 of transistor 205. That portion of the resulting output signal of transistor 202 not passing through resistor 206 to ground is fed into timer 178 and into RC charging network consisting of resistor 207 and capacitor 208. After a delay of about one minute by means of the charging network, transistor 209 conducts, which energizes relay 210, causing switch 211 to close. Closure of switch 211 couples the B+ voltage source to the RC network comprising resistor 212 and capacitor 213. After a delay of about one minute, the signal from this RC network causes transistor 214 to conduct, energizing relay 215, which closes switch 216. Closure of switch 216 activates monitor malfunction flashing alarm network 217 which includes resistors 218 and 219, transistors 220 and 221, capacitor 222, resistor 197, and light-emitting diode 223. If switch 224 is set in the preferred closed position, closure of switch 216 also energizes relay 226, opening normally closed switch 169 which de-energizes relay 117 and particle filter relay coil 134 and thus deactivates the particle filter.

The output signal from AND gate 98 which is applied to the base 204 of transistor 205 neutralizes the bias applied to the emitter 227 of transistor 205 from the B+ voltage source through resistor 228, zener diode 229 and resistor 230. When the output of AND gate 98 is zero, however, transistor 205 will conduct, energizing relay 231 and opening normally closed switch 232. Opening of switch 232 cuts off the power source to the collectors 233 and 234 of transistors 209 and 214, which reduces the effect of residual charge on the capacitors 208 and 213 at the input of transistors 209 and 214 and results in consistent timing.

If overheating is present after switch 179 of timer 178 is closed, e.g., 5 minutes after initiation of a reduction in machine load, the output from timer 178 will cause transistor 235 to conduct. The signal from transistor 235, whose emitter 236 is connected to ground through resistor 237, in turn activates trip relay coil 238, closing its contacts 239 to energize an external lockout relay (not shown), which then disconnects the excitation system and the remaining load from the machine, and also passes a signal through resistor 240 and turns on LED 241.

Operation

During machine overheating, with the control system set in the mode wherein overheating is validated prior to reduction in machine load (switch 139 preset to terminal 139B), and 75, 60 and 70 percent of full-scale used respectively for alert, alarm, and overheat reference signal levels, operation of the control system is as follows.

When the monitor signal applied to alert comparator 62 in FIG. 4 from overheat monitor 59 decreases to 75 percent, comparator 62 is activated turning on LED 96 and sending a signal to AND gate 98. When the monitor signal drops to 60 percent, alarm comparator 63 is activated, turning on LED 104 and sending a signal to AND gate 98. The output of comparator 63 is, after a 6-second delay, also sent to transistor 110, which fires SCR 116, closing switches 118 and 119. The closure of switch 118 connects power supply B+ to the relay coil 134, activating the particle filter of overheat monitor 59, and the closure of switch 119 connects the monitor signal to overheat comparator 64. When, after removal of pyrolysate particles from the gas flow the monitor signal recovers to 70 percent, overheat comparator 64 is activated and after a 1—2 second delay, fires SCR 155, which closes switches 157 and 158 and opens switch 167. Closure of switch 158 causes switches 118 and 119 to open, deactivating the relay coil 134 and the particle filter. Closure of switch 158 also energizes flashing alarm network 171, timer 178, relay 179, and then load reduction relay coil 140, the latter initiating a scheduled reduction of load of the dynamoelectric machine such as a $3\frac{1}{2}$ minute reduction in stator current to the point where no flow of liquid coolant is required to cool the stator windings. Closure of switch 157 is followed by a 45-second delay then transistor 183 conducts, which energizes relay 186, moving switch 106 to terminal 106B and connecting the output of comparator 64 to transistor 187. If monitor signal is less than or equal to 60 percent, transistor 187 will not conduct. If monitor signal is greater than 60 percent, indicating a cessation of overheating, transistor 187 will conduct and, with switch 194 preset in a closed position, switch 165 will open, opening switch 158, which deactivates the load reduction relay coil 140. At this point machine load may be restored by the operator.

If overheating continues for more than 5 minutes after initiation of load reduction, closure of switch 177 of timer 178 will result in closure of the contacts of trip relay coil 238, disconnecting the excitation system and the remaining load from the machine.

If it is desired to initiate load reduction prior to validation of machine overheating, switch 139 is preset to terminal 139A. With the control system in this mode, after activation of alarm comparator 63 and a 6-second delay, the firing of SCR 116 and closing of switch 118 will send a signal through switches 139 and 141 to load reduction relay 140, initiating reduction in machine load. A subsequent validation of overheating through activation of overheat comparator 64 will de-energize and then very quickly re-energize load reduction relay 140 through the action of switch 158, relay 170 and switch 141, and thus load reduction will continue.

Operation of the control system during a malfunction of the overheat monitor is identical to that with a machine overheat until after activation of the particle filter following a drop in monitor signal to 60 percent. During a monitor malfunction, monitor signal current will not recover to the 70 percent level and overheat comparator 64 will not be activated. Signals from alert comparator 62 and alarm comparator 63 will produce an output from AND gate 98 and after a one-minute delay, conduction of transistor 209 closes switch 211. After an additional one-minute delay, transistor 214 conducts, closing switch 216 which energizes flashing alarm network 217, indicating a malfunction of the overheat monitor. With switch 224 preset in a closed position, the closure of switch 216 also energizes relay 226, opening switches 169 and then 118, thus deactivating the particle filter relay 134.

It will be appreciated that if the control system is operated in the mode wherein load reduction is initiated prior to validation of machine overheating, i.e., with switch 139 preset to terminal 139A, switch 224 should be preset in a closed position so that in the event of a monitor malfunction, load reduction relay coil 140 will be de-energized through the opening of switches 169 and 118, and machine load reduction will cease.

To check operation of the control system, switch 61 is set to terminal 61A and the position of selector switch 72 is varied to provide signals to the system which simulate overheating or a monitor malfunction. For example, to determine whether the control system will correctly validate machine overheating, selector switch 72 is moved from position 90N (normal operation) to position 75A (alert), then the 60A (alarm) for at least 6 seconds to verify that the particle filter relay 135 has been activated, then is moved to position 700 (overheating). Malfunction of the overheat monitor can be simulated by moving selector switch 72 to position 75A (alert) then setting it at position 60A for at least two minutes.

## Claims

1. A control system for automatically verifying an apparent overheat signal from an overheat monitor (43) for use with a gas-cooled, dynamoelectric machine adapted to carry a predetermined electrical load wherein said monitor (43) includes a detector for sensing the presence of submicron particles in the cooling gas and a filter for removing submicron particles from the cooling gas passing through said monitor, and for initiating action based on the validity of said overheat signal, for ultimately disconnecting the excitation and the load from the dynamoelectric machine, said control system comprising an alarm network (31) responsive to said overheat signal, said alarm network being adapted to initiate filtration cooling gas passing through said monitor (43) in response to a drop in said overheat signal to a first preselected value, and

an overheat network (34, 35, 36) responsive to said overheat signal and adapted to initiate a reduction in the loading of said dynamoelectric machine in response to a rise in said monitor signal to a second preselected value within a preselected interval of time after said monitor signal drops to said first preselected value,

characterized by a trip network (42) adapted to disconnect the excitation system and the load from said dynamoelectric machine in response to the combination of a rise in said monitor signal to said second preselected value within a first preselected interval of time after said monitor signal drops to said first preselected value and the existence of a monitor signal less than or equal to said first preselected value at the expiration of a second preselected interval of time after said monitor signal rises to said second preselected value.

2. The control system according to claim 1, characterized by a monitor malfunction alarm (40) connected to said alarm network (31), said monitor malfunction alarm being adapted to indicate a malfunction of the overheat monitor (43) in the absence of a rise in said monitor signal to a value above said first preselected value within a preselected interval of time after said monitor signal drops to said first preselected value.

3. The control system according to claim 1 or 2, characterized by an alert network (30) responsive to said monitor signal, said alert network adapted to indicate an alert condition of the overheat monitor (43) in response to a drop in said monitor signal to a third preselected value, said third preselected value being greater than said first preselected value.

4. The control system according to claim 2, characterized in that said monitor malfunction alarm (40) is connected to an AND gate (38), a delay network (39), and a light-emitting diode, and that said trip network (42) is associated with a timer (41) and includes a trip relay coil (238).

5. The control system according to claim 1, characterized in that said overheat monitor (43) further includes a recorder for plotting monitor signals, and said first, second, and third preselected values of said monitor signal are, respectively 60, 70, and 75 percent of full-scale reading on said recorder.

6. The control system according to any one of claims 1 to 5, further including a test network (45) for checking operation of the control system by simulating machine overheating or a malfunction of said overheat monitor (43).

**Revendications**

1. Système de commande pour la vérification automatique d'un signal de surchauffe apparente provenant d'un dispositif de contrôle de surchauffe (43) utilisé dans une machine dynamoélectrique refroidie au gaz adaptée pour supporter une charge électrique prédéterminée, dans lequel le dispositif de contrôle de surchauffe (43) comporte. un détecteur pour détecter la présence de particules de taille inférieure au micron dans le gaz réfrigérant et un filtre pour enlever ces particules de taille inférieure au micron du gaz réfrigérant passant dans le dispositif de contrôle, et pour amorcer une action basée sur la validité du signal de surchauffe, pour finalement débrancher l'excitation et la charge de la machine dynamoélectrique, le système de commande comportant un circuit d'alarme (31) sensible au signal de surchauffe, ce circuit d'alarme étant adapté pour amorcer le filtrage du gaz réfrigérant passant dans le dispositif de contrôle (43) en réponse à une baisse du signal de surchauffe jusqu'à une première valeur prédéterminée, et un circuit de surchauffe (34, 35, 36) sensible à ce signal de surchauffe et adapté pour amorcer une réduction de la charge de la machine dynamoélectrique en réponse à une augmentation du signal de contrôle jusqu'à une deuxième valeur prédéterminée dans un intervalle de temps prédéterminé après que le signal de contrôle ait chuté jusqu'à la première valeur prédéterminée; système de commande caractérisé en ce qu'il comporte un circuit de débranchement (42) adapté pour débrancher le système d'excitation et la charge de la machine dynamoélectrique en réponse à une élévation du signal de contrôle jusqu'à la seconde valeur prédéterminée dans un premier intervalle de temps prédéterminé après que le signal de contrôle a diminué jusqu'à la première valeur prédéterminée et l'existence d'un signal de contrôle inférieur ou égal à la première valeur prédéterminée à la fin d'un deuxième intervalle de temps prédéterminé après que le signal de contrôle a augmenté jusqu'à la seconde valeur prédéterminée.

2. Système de commande selon la revendication 1, caractérisé en ce qu'il comporte une alarme (40) de défaillance du dispositif de contrôle reliée au circuit d'alarme (31), cette alarme de défaillance du dispositif de contrôle étant adaptée pour indiquer une défaillance du dispositif de contrôle de surchauffe (43) en l'absence d'une augmentation du signal de contrôle jusqu'à une valeur au-dessus de la première valeur prédéterminée dans un intervalle de temps prédéterminé après que le signal de contrôle ait diminué jusqu'à la première valeur prédéterminée.

3. Système de commande selon l'une quelconque des revendications 1 ou 2, caractérisé en ce qu'il comporte un circuit d'avertissement (30) sensible au signal de contrôle, ce circuit d'avertissement étant adapté pour indiquer un état d'avertissement du dispositif de contrôle de surchauffe (43) en réponse à une baisse du signal de surchauffe jusqu'à une troisième valeur prédéterminée, cette troisième valeur prédéterminée étant supérieure à la première valeur prédéterminée.

4. Système de commande selon la revendication 2, caractérisé en ce que l'alarme de défaillance (40) du dispositif de contrôle, est reliée à une porte ET (38), un circuit à retard (39) et une diode à émission de lumière, et en ce que le circuit de débranchement (42) est associé à un temporisateur (41) et comporte une bobine à retard de débranchement (238).

5. Système de commande selon la revendication 1, caractérisé en ce que le dispositif de contrôle de surchauffe (43) comporte en outre un enregistreur pour relever les signaux de surchauffe et en ce que les première, deuxième et troisième valeurs prédéterminées du signal de contrôle ont respectivement 60, 70 et 75 pour cent de la valeur totale de l'échelle de lecture de l'enregistreur.

6. Système de commande selon l'une quelconque des revendications 1 à 5, caractérisé en ce qu'il comporte en outre un circuit d'essai (45) pour vérifier le fonctionnement du système de commande en simulant une surchauffe de la machine ou une défaillance du dispositif de contrôle de surchauffe (43).

**Patentansprüche**

1. Steuersystem zum automatischen Feststellen eines auftretenden Überhitzungssignals von einem Überhitzungsmonitor (43) zur Verwendung in einer gasgekühlten dynamoelektrischen Maschine, die für eine vorbestimmte elektrische Last geeignet ist, wobei der Monitor (43) einen Detektor zum Abtasten der Gegenwart von Submikronteilchen in dem Kühlgas und ein Filter zum Beseitigen der Submikronteilchen aus dem durch den Monitor geleiteten Kühlgas aufweist, und zum Einleiten eines Vorgangs auf der Basis der Gültigkeit des Überhitzungssignals zum letzendlichen Trennen der Erregung und der Last von der dynamoelektrischen Maschine, wobei das Steuersystem eine auf das Überhitzungssignal ansprechende Alarmschaltung (31), die in der Lage ist, die Filterung des durch den Monitor geleiteten Kühlgases bei einem Abfall des Überhitzungssignals auf einen ersten vorgewählten Wert einzuleiten, und eine Überhitzungsschaltung (34, 35, 36) aufweist, die auf das Überhitzungssignal anspricht und eine Verringerung der Last der dynamoelektrischen Maschine einleiten kann bei einem Anstieg des Monitorsignals auf einen zweiten vorgewählten Wert innerhalb eines vorgewählten Zeitintervalls nach dem Abfall des Monitorsignals auf den ersten vorgewählten Wert, gekennzeichnet durch eine Auslöseschaltung (42), die das Erregersystem und die Last von der dynamoelektrischen Maschine trennen kann bei der Kombination eines Anstieges des Monitorsignals auf den zweiten vorgewählten Wert innerhalb eines ersten vorgewählten Zeitintervalls nach dem Abfall des Monitorsignals auf den ersten vorgewählten Wert und dem Auftreten eines Monitorsignals, das gleich oder kleiner als der erste vorgewählte Wert ist, am Ende eines zweiten vorgewählten Zeitintervalls nach dem Anstieg des Monitorsignals auf den zweiten vorgewählten Wert.

2. Steuersystem nach Anspruch 1, gekennzeichnet durch einen mit der Alarmschaltung (31) verbundenen Monitor-Fehlfunktionsalarm (40), der eine Fehlfunktion des Überhitzungsmonitors (43) anzeigen kann beim Fehlen eines Antiegs des Monitorsignals auf einen Wert oberhalb des ersten vorgewählten Wertes innerhalb eines vorgewählten Zeitintervalls nach dem Abfall des Monitorsignals auf den ersten vorgewählten Wert.

3. Steuersystem nach Anspruch 1 oder 2, gekennzeichnet durch eine auf das Monitorsignal ansprechende Warnschaltung (30), die einen Warnzustand des Überhitzungsmonitors (43) anzeigen kann bei einem Abfall des Monitorsignals auf einen dritten vorgewählten Wert, der größer als der erste vorgewählte Wert ist.

4. Steuersystem nach Anspruch 2, dadurch gekennzeichnet, daß der Monitor-Fehlfunktionsalarm (40) mit einem UND-Gatter (38), einer Verzögerungsschaltung (39) und einer Licht-emittierenden Diode verbunden ist, und daß die Auslöseschaltung (42), der eine Zeitsteuerung (41) zugeordnet ist, eine Auslöserelaisspule (238) aufweist.

5. Steuersystem nach Anspruch 1, dadurch gekennzeichnet, daß der Überhitzungsmonitor (43) ferner ein Aufzeichnungsgerät zum Zeichnen von Monitorsignalen aufweist, und die ersten, zweiten und dritten vorgewählten Werte des Monitorsignals 60, 70 bzw. 75% der vollen Anzeige des Aufzeichnungsgerätes betragen.

6. Steuersystem nach einem der Ansprüche 1 bis 5, wobei ferner eine Prüfschaltung (45) vorgesehen ist zum Prüfen des Betriebs des Steuersystems durch Simulieren einer Überhitzung der Maschine oder einer Fehlfunktion des Überhitzungsmonitors (43).

Fig. 1

0 000 585

Fig. 2

*Fig. 3*

Fig. 4a

Fig. 4b